# EUROPEAN PATENT SPECIFICATION

(11) **EP 0 178 933 B1**
(45) Date of publication and mention of the grant of the patent: **09.06.1993**
(21) Application number: 85307504.2
(22) Date of filing: 17.10.1985
(51) Int. Cl.: H03H 17/02, G01R 23/16

(54) **Auto-correlation filter**
Autokorrelationsfilter
Filtre à autocorrélation

(30) Priority: 17.10.1984 JP 219240/84
(43) Date of publication of application: 23.04.1986
(73) Proprietor: SHARP KABUSHIKI KAISHA, Osaka 545 (JP)
(72) Inventor: Fujimoto, Yoshiji, Nara-shi Nara-ken (JP)
(74) Representative: Wright, Peter David John

(56) References cited:
- IEEE TRANSACTIONS ON INDUSTRIAL ELECTRONICS, vol. IE-29, no. 1, February 1982, pages 73-82, IEEE, New York, US; S. GANESAN et al.: "A real-time digital signal analyser correlator average power spectral density analyzer"

## Description

### BACKGROUND OF THE INVENTION

### Field of the Invention

The present invention relates to a filter for providing powers of a signal passing through specified frequency bands for each frame (short time division).

### Description of the Prior Art

In spectrum analysis and sound identification, FFT (fast fourier transform) and digital filter bands are two typical methods for obtaining the power of a signal of a particular frequency band through digital processing.

Method with FFT is as follows. First, the FFT of a signal waveform gives the power of each frequency component. Then, the powers of the frequency components are multiplied by the weights corresponding to the frequency response of the filter and summed up, so that the power for each frame is obtained. This method is advantageous in that a filter of a desired frequency response is easily realized. The problem is, however, that FFT requires many complicated calculations.

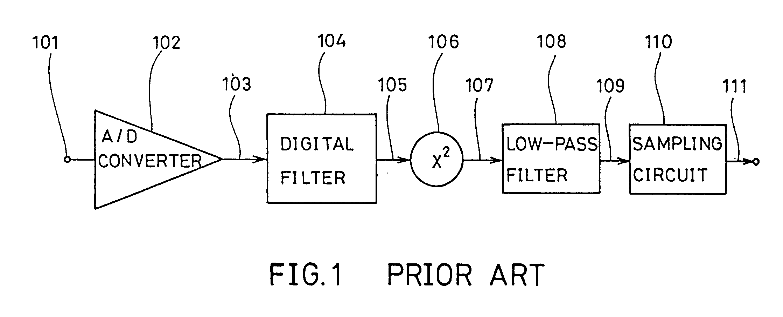

Method with a digital filter is as follows. After a signal is passed through a specified filter, the filtered signal detection is squared for power calculation. Then, the signal is passed through a low-pass-filter to sample the power for each frame. Referring to Fig. 1, an analog signal 101 is converted by an analog/digital converter 102 to a digital signal 103 which is passed through a digital filter 104 with a specified frequency response so as to obtain a signal 105 having the pass-band frequency components. Then, the signal 105 is passed through a square circuit 106 to square the signal value, thus obtaining an instantaneous power signal 107. The signal 107 is then passed through an anti-alias low-pass-filter 108 to obtain a reflected noise-free signal 109 which is sampled by a sampling circuit 110 at frame intervals to obtain output power 111.

Though this digital filter method involves fewer calculation stages, it is necessary to increase the number of degrees of the digital filter to improve the cut-off frequency response of the filter, resulting in increased labour for calculation after all. In addition, the number of calculations increase in proportion to the number of filter channels.

### OBJECTS AND SUMMARY OF THE INVENTION

### Objects of the Invention

Accordingly, an object of the present invention is to provide a novel auto-correlation filter which calculates the power of the signal passed through a filter with a specific frequency response for each frame.

Another object of the present invention is to provide the structure of the auto-correlation filter realized by the small number of calculations of auto-correlation functions and their linear-combination.

Other objects and further scope of applicability of the present invention will become apparent from the detailed description given hereinafter. It should be understood, however, that the detailed description and specific examples, while indicating preferred embodiments of the invention, are given by way of illustration only, since various changes and modifications within the scope of the invention will become apparent to those skilled in the art from this detailed description.

### Summary of the Invention

Pursuant to an embodiment of the present invention there is provided a filter for providing a power of an input signal in a predetermined time interval (M) comprising:
means for obtaining auto-correlation functions of said input signal; and
means for obtaining a linear-combination of said auto-correlation functions, said linear-combination being available as said power.

Further the filter may comprise means for providing coefficients defined by a cosine transformation of frequency response of said filter, said coefficients being used by said means for obtaining a linear-combination of said auto-correlation functions. Preferably the filter may comprise means for providing coefficients defined by a cosine transformation of frequency response of said filter and a window function for reducing the number of degrees of said auto-correlation functions, said coefficients being used by said means for obtaining a linear-combination of said auto-correlation functions.

Pursuant to another embodiment of the present invention there is also provided a filter for providing plural powers of an input signal in a predetermined time interval (M), each of said plural powers corresponding to one of plural channels, comprising:
means for obtaining auto-correlation functions of said input signal;
means for providing plural sets of coefficients, each of said sets corresponding to one of said channels; and
means for obtaining linear-combinations of said auto-correlation functions for said channels by using said sets of coefficients, said linear-combinations being available as said powers.

Conveniently, there is provided a method for providing a power of an input signal in a predetermined time interval, comprising the steps of:
obtaining auto-correlation functions of said input signal; and
obtaining a linear-combination of said auto-correlation functions by using linear-combination coefficients, said linear-combination being available as said power, and a method for providing plural powers of an input signal in a predetermined time interval, each of said plural powers corresponding to one of plural channels, comprising the steps of:
obtaining auto-correlation functions of said input signal;
providing plural sets of coefficients, each of said sets corresponding to one of said channels; and
obtaining linear-combinations of said auto-correlation functions for said channels by using said sets of coefficients, said linear-combinations being available as said powers.

The number of the calculations involved in the filter of the present invention is obtained by the following formulas in which N is the number of sampling points in one frame, L being the number of channels to be realized, with the assumption that the degree of auto-correlation functions is from 0 to M:
(1) Calculation of auto-correlation
   Number of times of multiplications: $\text{N x (M+1)}$
   Number of times of additions: $\text{(N-1) x (M+1)}$
(2) Calculation of filter power by linear-combination
   Number of times of multiplications: $\text{(M+1) x L}$
   Number of times of additions: M x L
As understood from these formulas, since M is extremely smaller than N (for example, N = 200, M = 20), the entire calculation volume does not increase significantly even if the number of channels L increases. Accordingly, the filter of the present invention is very useful in speech recognition and general spectrum analysis operations which require numerous filter channels.

Further, the filter whose calculations mainly consist of sum of products is suitable to a digital signal processor that is quick in the sum-of-products calculation.

### BRIEF DESCRIPTION OF THE DRAWINGS

The present invention will be better understood from the detailed description given hereinbelow and the accompanying drawings which are given by way of illustration only, and thus are not limitative of the present invention and wherein:
Fig. 1 is a block diagram of a conventional digital filter circuit;
Fig. 2 is a block diagram of an embodiment of a filter of the present invention;
Fig. 3 is a circuit diagram of the filter of Fig. 2;
Fig. 4 is an operation timing chart of the filter of Fig. 3;
Fig. 5 is a graph showing an example of the linear-combination coefficients of a band-pass-filter;
Fig. 6 is a graph showing an example of the linear-combination coefficients multiplied by a rectangular window;
Fig. 7 is a graph showing an example of the cosine transformation result of the rectangular window function;
Fig. 8. is a graph showing an example of the filter frequency response when the linear-combination coefficients are multiplied by the rectangular window;
Fig. 9 is a graph showing an example of the linear-combination coefficients multiplied by a Hanning window;
Fig. 10 is a graph showing an example of the cosine transformation result of the Hanning window;
Fig. 11 is a graph showing an example of the filter frequency response when the linear-combination coefficients are multiplied by the Hanning window;
Fig. 12 is a graph showing an example of the linear-combination coefficients multiplied by a Hamming window;
Fig. 13 is a graph showing an example of the cosine transformation result of the Hamming window; and
Fig. 14 is a graph showing an example of the filter frequency response when the linear-combination coefficients are multiplied by the Hamming window.

### DESCRIPTION OF THE PREFERRED EMBODIMENTS

An embodiment of the present invention will be described in details in the order of:
A: Principle and Advantageous Feature
B: Example of Filter Design
C: Specific Construction

### A: Principle and Advantageous Feature

Auto-correlation function φ(τ) and power spectrum Φ(ω) have such well-know relation as expressed by the equations (1) and (2) below. 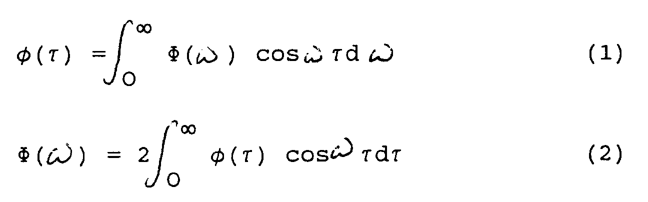
For application to sampled digital signals, these equations are transformed as follows, by using the auto-correlation functions for the short time division (frame) in a discrete time system: 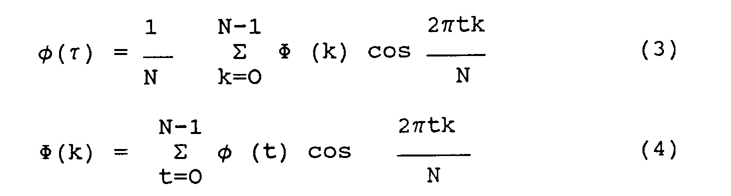
Here, 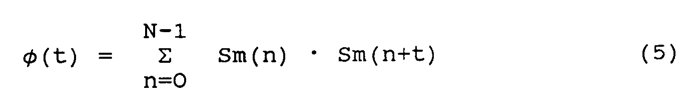
in which Sm(n) is a sampled input signal series in the "m"th frame and is equal to $\text{Sm(n+N)}$ , and N is the number of sampling points in one frame.

Supposing F(k) is an ideal frequency response of a filter to be designed, the output power P_{F} of each frame of the filter is expressed in the following equation in which products of F(k) and Φ(k) are summed up for "k": 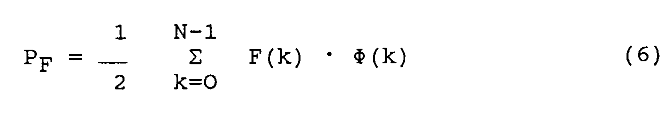
If this equation is expanded using the equation (4), the following equation is obtained. 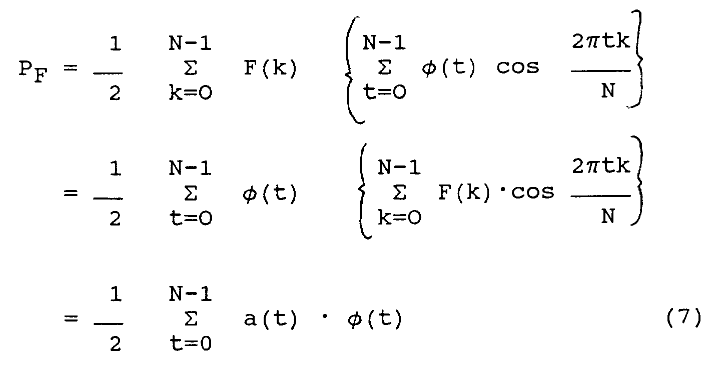
It is understood from the above that the output power P_{F} of the filter is the linear-combination of auto-correlation function Φ(t). Here, 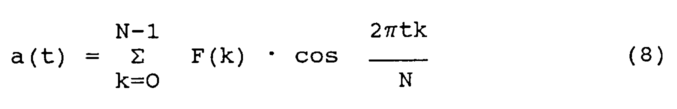
That is, a(t) is a cosine transformation of F(k). By inverse cosine transformation, the following equation is obtained: 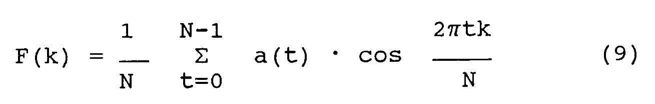
Now, when the auto-correlation functions are multiplied by a window function ω (t) to cut the calculations at a certain degree of the auto-correlation functions, the linear-combination coefficients a_{ω} (t) can be calculated by the equation:

${\text{a}}_{\text{ω}} \text{(t) = a (t) · ω (t) (10}$ )

Assuming the window function ω (t) is equal to ω(-t) and that the inverse cosine transformation of ω(t) is W(k), the filter frequency response F_{w}(k) multiplied by the window function is obtained by using a_{ω}(t) in place of a(t) in the equation (9). 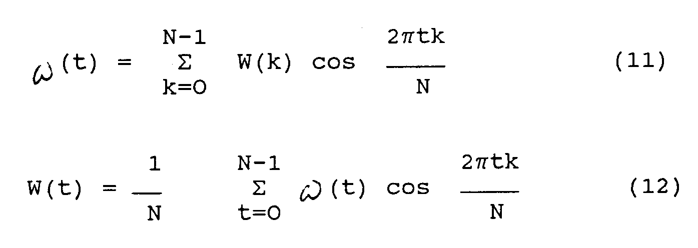 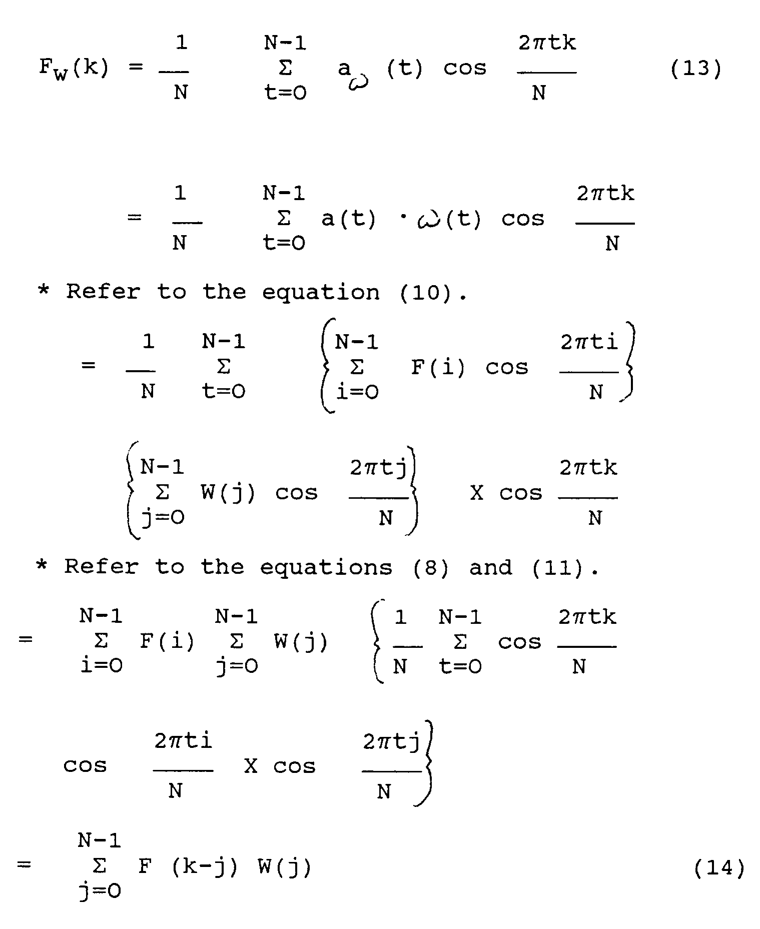
Thus, F_{w}(k) is expressed as a convolution of the original frequency response F(k) and W(k).

The principle of the present invention has been described above. It deserves attention that the calculation of auto-correlation functions is the same for any frequency response of a filter, excepting that the linear-combination coefficients for each auto-correlation function is different. Since the degree of coefficients can be limited by the window function, memory capacity for storing coefficients and the number of calculations for linear-combination is reduced.

Consequently, the filter of the present invention is very convenient in realizing filter bands used for spectrum analysis and speech recognition, that is, multichannel band-pass-filters. However many channels the filter bands may have, calculation is needed only once to the specified degree of the auto-correlation functions. Calculation for the linear-combination must be executed for each channel, but the number of the calculation is small. Moreover, since a limited number of linear-combination coefficients determines the frequency response of a filter, the memory for storing coefficients need not have a large capacity.

Unlike an IIR filter, the filter of the present invention does not contain a feedback loop, and therefore does not present a problem such as limit cycle.

### B. Example of Filter Design

An example of the band-pass-filter design based on the above principle will be shown in the following.

The filter to be designed has a sampling frequency of 10kHz, 200 sampling points for a frame, and a passing band of 2,200 ^{∼} 2,600 Hz. An ideal filter must have such frequency response that the attenuation in the passing band is 0dB and that in the blocking band is -100dB.

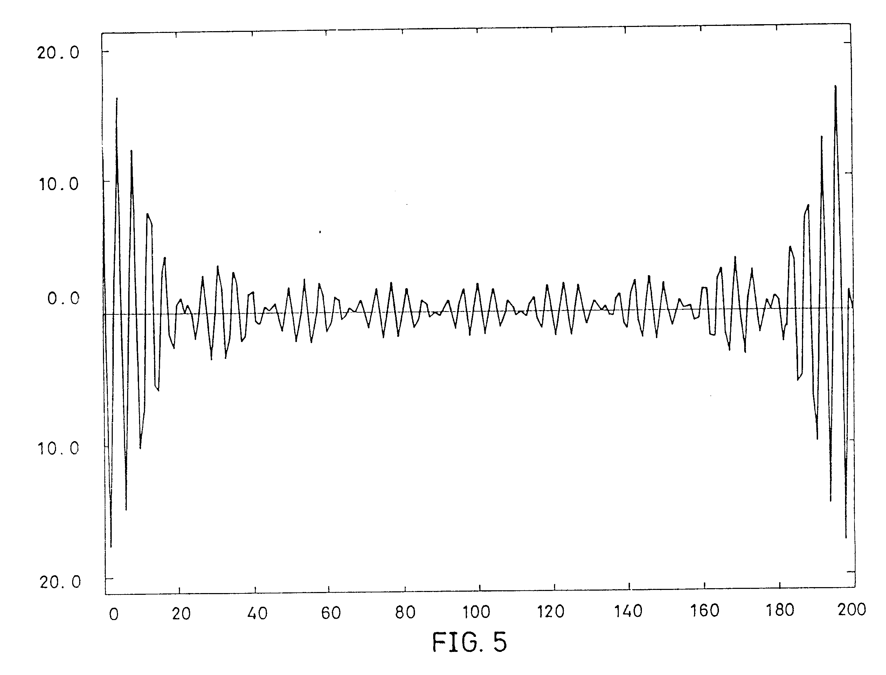

Fig. 5 shows the linear-combination coefficients for the frequency response of the ideal filter calculated by the cosine transformation of the equation (8). The coefficients are symmetrical with respect to the 100 sample time. The auto-correlation functions themselves are also symmetrical. Therefore, sum-of-products calculation are needed only up to the 100 sample time; division by 2 is not necessary.

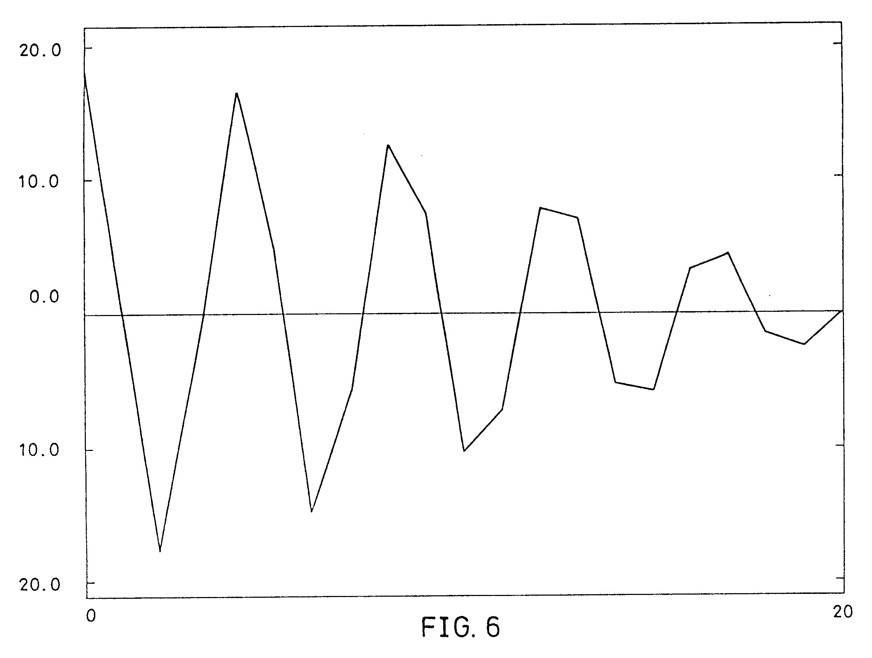

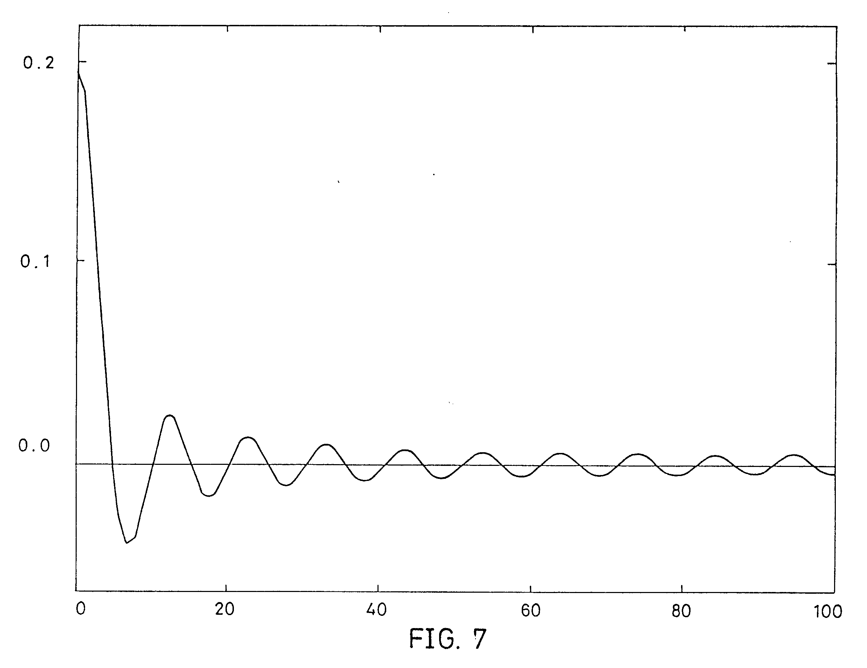

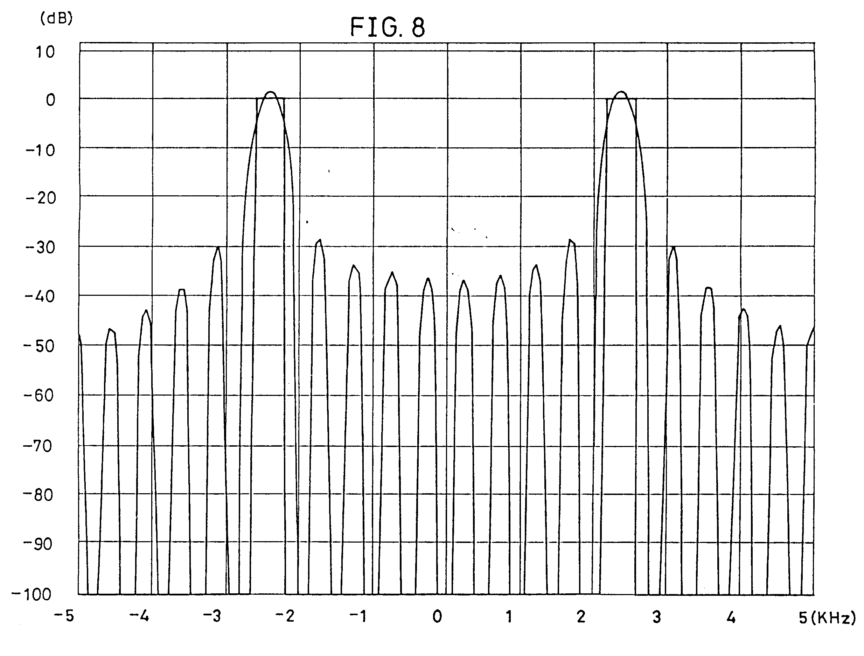

Fig. 6 shows the weighted coefficients of the equation (10), with the value for the auto-correlation functions up to the 25 sample time being restricted by a rectangular window. The cosine transformation of the rectangular window is shown in Fig. 7. Calculation of the convolution equation (14) between the cosine transformation of the rectangular window and the ideal filter frequency response yields the frequency response corresponding to the rectangular window as shown in Fig. 8. This frequency response with a large (-30dB) side lobe can be improved by raising the degree of the auto-correlation functions. In Fig. 8, the thick lines indicate an ideal band-pass-filter.

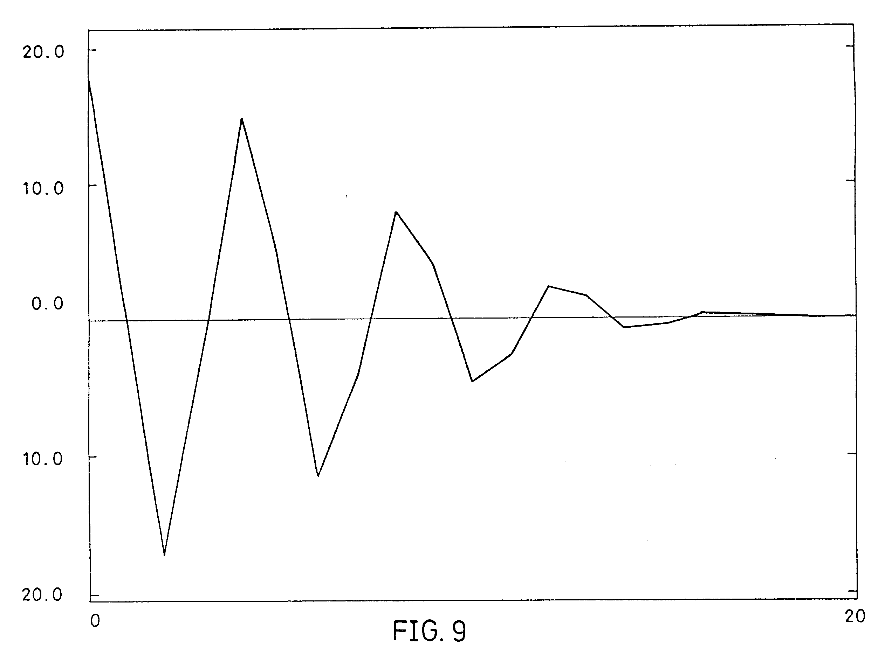

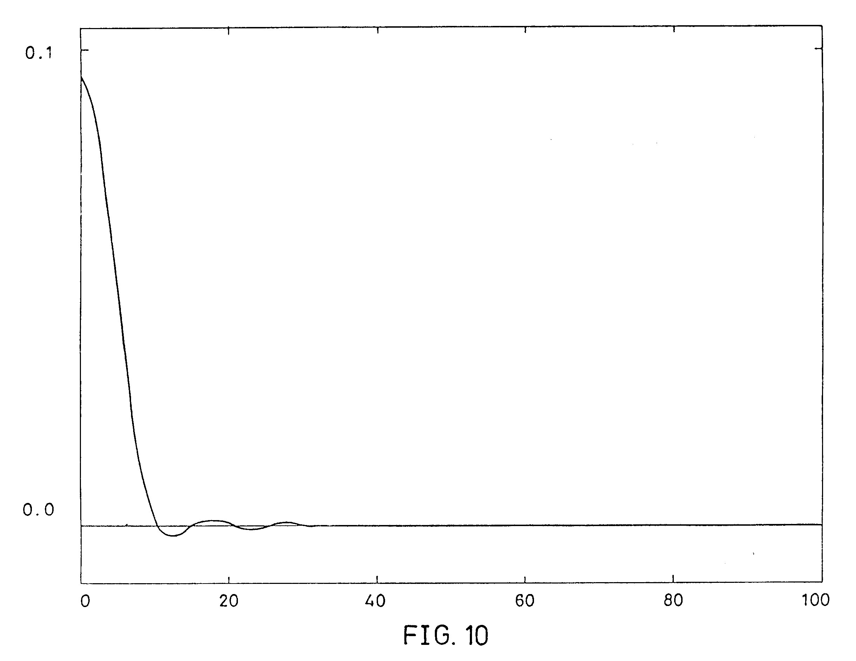

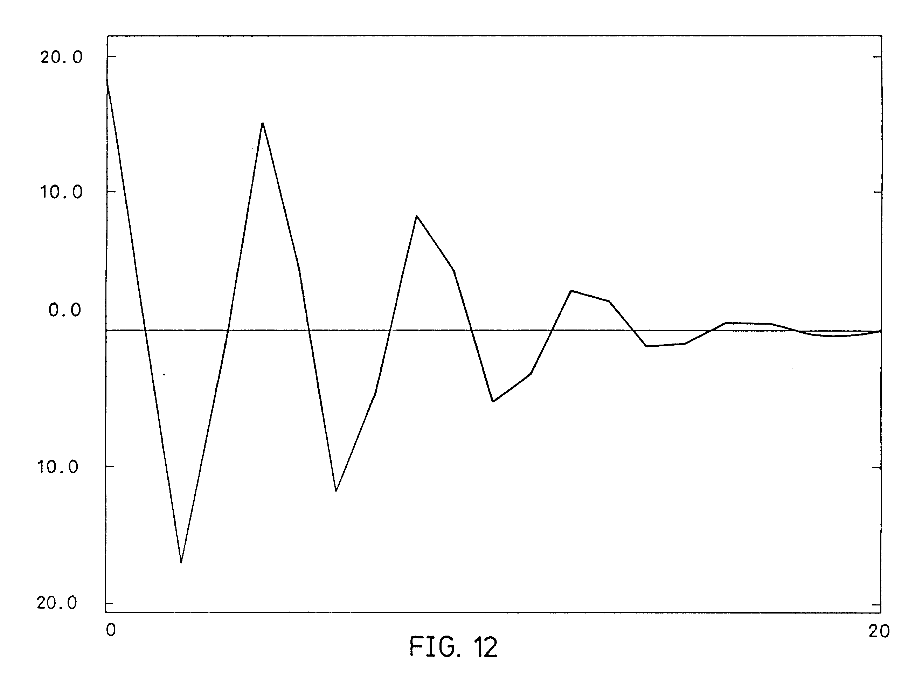

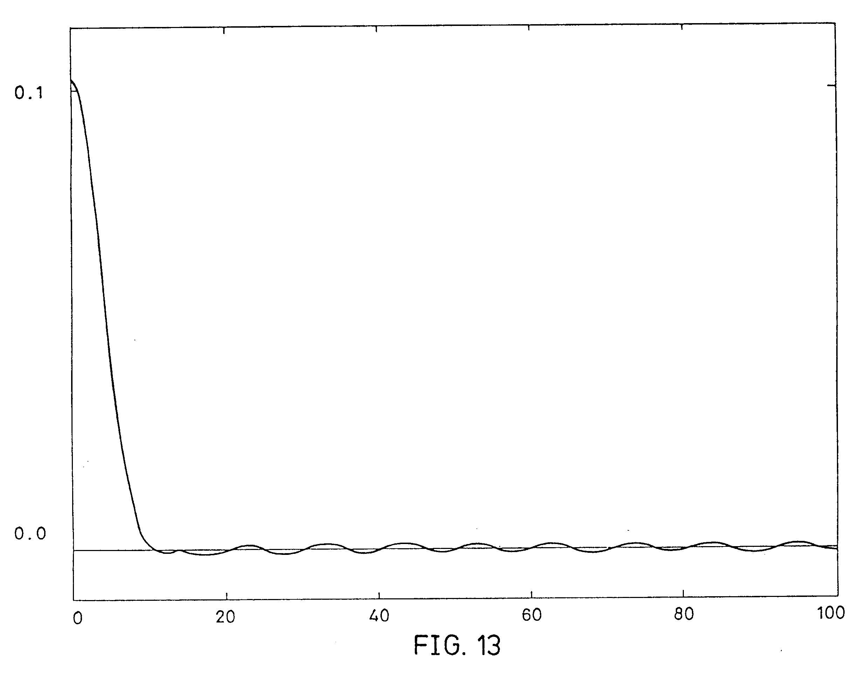

The linear-combination coefficients of the auto-correlation functions restricted by a Hanning window instead of the rectangular window, the cosine transformation of the Hanning window and the frequency response are shown in Figs. 9, 10 and 11, respectively. The linear-combination coefficients of the auto-correlation functions restricted by a Hamming window, the cosine transformation of the Hamming window and the frequency response are shown in Figs. 12, 13 and 14, respectively.

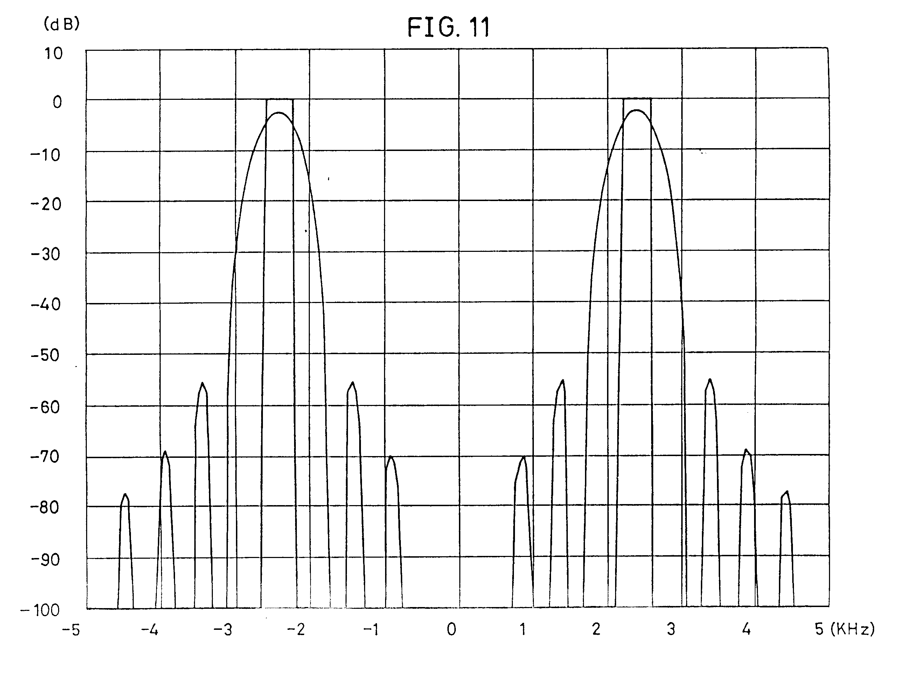

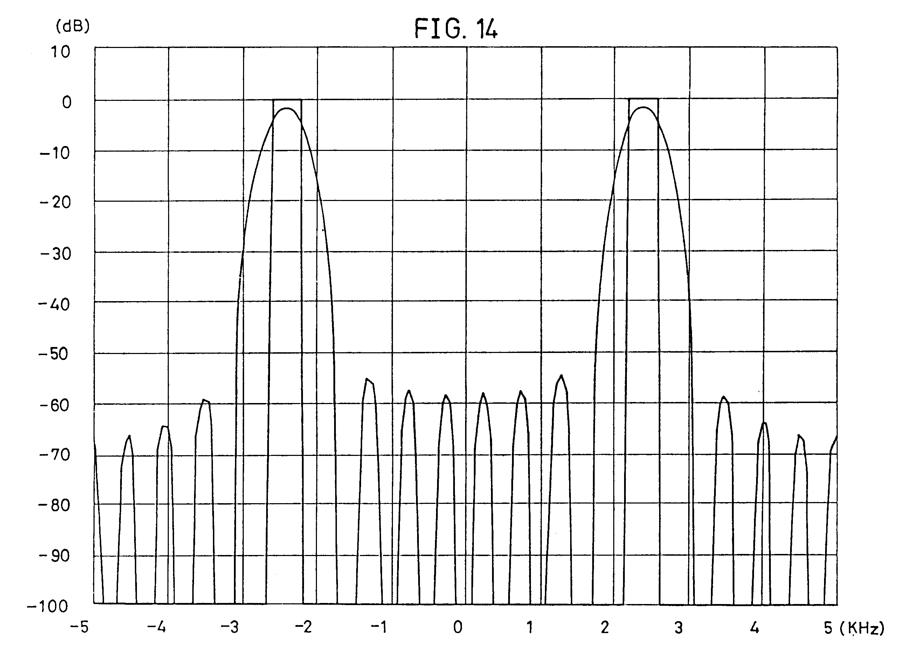

The frequency responses in Figs. 11 and 14 have very small side lobes (-55dB) but present very wide passing bands. In designing the filter of the present invention, it is necessary to select a suitable degree for the auto-correlation functions and an appropriate window function according to the purpose.

### C. Specific Construction

Specific construction of the auto-correlation filter design will be described in the following.

For explanatory purpose, the degree of the auto-correlation functions for the filter of the present invention is assumed to be 0 to 9.

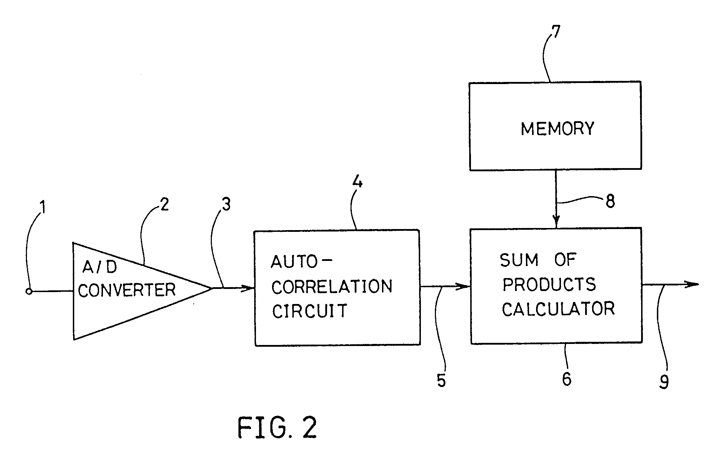

Fig. 2 shows the entire construction of a filter of the present invention. An analog signal input from an input terminal 1 is converted to a digital signal 3 by an analog/digital converter 2. The digital signal 3 enters an auto-correlation circuit 4 where the auto-correlation functions are calculated for each frame and outputted. The auto-correlation functions 5 enter a sum-of-products calculator 6 where they are multiplied by linear-combination coefficients 8 read from a memory 7 and the products are summed up as indicated by the equation (7). The sum is outputted as the power 9 of the filter.

If the memory 7 has stored the coefficients for many kinds of auto-correlation filters, outputs of many auto-correlation filters are easily obtained by executing sum-of-products calculation for the auto-correlation functions and the coefficients sequentially read from the memory 7.

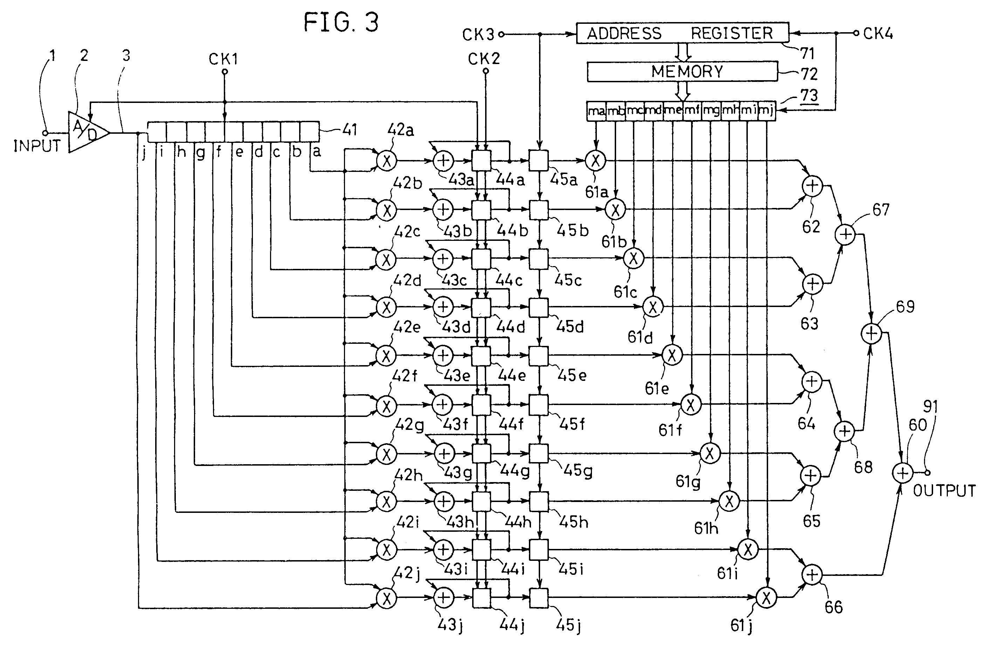

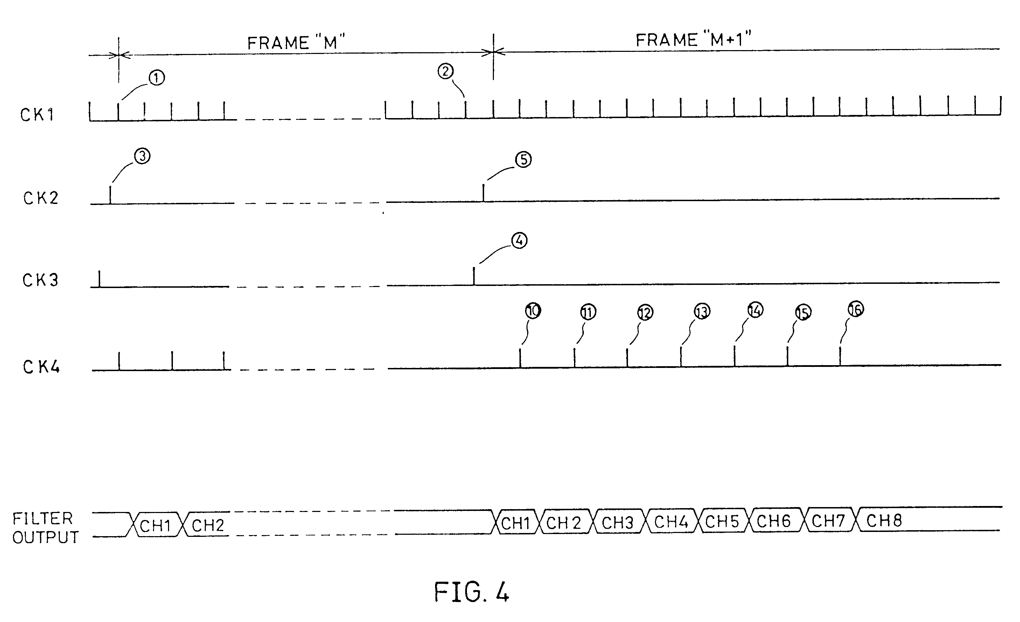

Now, the circuit of the auto-correlation filter and the operation timing will be described in detail with reference to Figs. 3 and 4. In this description, it is assumed that the memory 7 stores auto-correlation filter coefficients for 8 channels.

In Fig. 3, analog signal inputs 1 are converted by an A/D converter 2 to digital signals 3 which are stored in a shift register 41 sequentially. The shift register 41 and the A/D converter 2 are operated synchronously with a sampling clock signal CK1 which is continuously supplied at a constant interval as shown in Fig. 4. The length of frame is determined for calculating the power of the auto-correlation filter. The number of sampling points for one frame is N in the equation (5). In Fig. 4, the "m"th frame comprises the sampling pulses from ① to ②.

Among the digital signals 3 stored in the shift register 41, the last data "a" and each data of "b" ^{∼} "j" stage are transmitted to a respective multiplier of 42a ^{∼} 42j where the auto-correlation functions are calculated. For calculation of the auto-correlation function of the 0th degree, the last data "a" of the shift register 41 is squared. For calculation of the auto-correlation function of the 1st degree, the last data "a" is multiplied by the previous data "b". Thus, auto-correlation functions of up to the 9th degree are calculated by multiplying the last data "a" and the data "c" ^{∼} "j" in the shift register 41. The data outputs from the multipliers 42a ^{∼} 42j are supplied to the corresponding adders 43a ^{∼} 43j to obtain the sum for one frame.

In the adders 43a ^{∼} 43j, outputs from the corresponding multipliers 42a ^{∼} 42j are added to the outputs from the corresponding registers 44a ^{∼} 44j of the next stage, the results being stored into the corresponding registers 44a ^{∼} 44j which retain partial sums. The partial sum registers 44a ^{∼} 44j are cleared by the pulse ③ of the clock signal CK2 shown in Fig. 4. Thereafter, the outputs from the adders 43a ^{∼} 43j are set by the clock pulses (from ① to ②) of the clock signal CK1 as partial sums for one frame. The partial sum set by the last clock pulse 2 for one frame is the total sum or the auto-correlation functions for the frame.

The partial sum registers 44a ^{∼} 44j transfer the auto-correlation functions to the following auto-correlation registers 45a ^{∼} 45j by the pulse ④ of the clock signal CK3, so that the partial sum registers 44a ^{∼} 44j are available for calculation for the next frame. After this data transfer, the partial sum registers 44a ^{∼} 44j are cleared by the pulse ⑤ of the clock signal CK2 to be available for retaining the partial sums for the next frame.

Meanwhile, an address register 71 of the memory 72 is initialized for the address that stores the linear-combination coefficients a₁(t) of the No. 1 channel by the pulse ④ of the clock signal CK3. Given this address, the memory 72 outputs linear-combination coefficients a₁(0), a₁(1), ... a₁(9) of the No. 1 channel, the values being set in the respective areas of a memory register 73 by the pulse 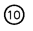 of the clock signal CK4. Simultaneously, the address register 71 is counted up by one of the pulse 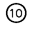 of the clock signal CK4 so as to designate the address storing the linear-combination coefficients a₂(t) of the No. 2 channel. Similarly, by the pulses 11 ^{∼} 16 of the clock signal CK4, linear-combination coefficients of the subsequent channels are read from the memory 72 and set in the memory register 73 in turn.

The auto-correlation functions preliminarily calculated and retained in the auto-correlation registers 45a ^{∼} 45j are multiplied by the corresponding linear-combination coefficients set in the memory register 73 in respective multipliers 61a ^{∼} 61j. Specifically, the multiplier 61a multiplies the auto-correlation function of the 0th degree stored in the auto-correlation register 45a and the linear coupling coefficient a₁(0) stored in the area "ma" of the memory register 73. Thus, the auto-correlation functions of the 1st to the 9th degree are multiplied by a₁(1) ..., and a₁(9) in the multipliers 61a ^{∼} 61j, and the products are outputted.

The product outputs are summed up by adders 62 ^{∼} 69 and 60, and the total sum is outputted from an output terminal 91 as a filter output. As shown in Fig. 4, the output terminal 91 outputs power CH1 of the No. 1 channel of the filter at first. Powers CH2 ^{∼} CH8 of the No. 2 ^{∼} No. 8 channels of the filter are outputted sequentially as linear-combination coefficients for these channels are set in the memory registers by the clock pulses 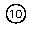 ^{∼} 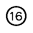 of the clock signal CK4.

The invention being thus described, it will be obvious that the same may be varied in many ways. Such variations are not to be regarded as a departure from the scope of the invention.

## Claims

1. A filter for providing a power (9) of an input signal (3) in a predetermined time interval (M) comprising:
means (4) for obtaining auto-correlation functions (5) of said input signal (3); and
means (6) for obtaining a linear-combination of said auto-correlation functions, said linear-combination being available as said power (9).

2. A filter according to claim 1, wherein said means (4) for obtaining auto-correlation functions (5) is an auto-correlation circuit (41-45).

3. A filter according to claim 1, wherein said means (6) for obtaining a linear-combination of said auto-correlation functions is a sum of products circuit (61a-61j, 60, 62-69).

4. A filter according to claim 1, further comprising means (7) for providing coefficients defined by a cosine transformation of frequency response of said filter, said coefficients being used by said means (6) for obtaining a linear-combination of said auto-correlation functions.

5. A filter according to claim 4, wherein said means (7) for providing coefficients comprises a memory means for storing said coefficients.

6. A filter according to claim 1, further comprising means (7) for providing coefficients defined by a cosine transformation of frequency response of said filter and a window function for reducing the number of degrees of said auto-correlation functions (5), said coefficients being used by said means (6) for obtaining a linear-combination of said auto-correlation functions.

7. A filter according to claim 6, wherein said means (7) for providing coefficients comprises a memory means for storing said coefficients.

8. A filter for providing plural powers (9) of an input signal (3) in a predetermined time interval (M), each of said plural powers corresponding to one of plural channels, comprising:
means (4) for obtaining auto-correlation functions (5) of said input signal (3);
means (7) for providing plural sets of coefficients, each of said sets corresponding to one of said channels; and
means (6) for obtaining linear-combinations of said auto-correlation functions for said channels by using said sets of coefficients, said linear-combinations being available as said powers (9).

9. A filter according to claim 8, wherein said means (7) for providing plural sets of coefficients comprises memory means which sequentially supplies said sets of coefficients to said means (6) for obtaining linear-combinations of said auto-correlation functions.

10. A method for providing a power of an input signal in a predetermined time interval, comprising the steps of:
obtaining auto-correlation functions of said input signal; and
obtaining a linear-combination of said auto-correlation functions by using linear-combination coefficients, said linear-combination being available as said power.

11. A method for providing plural powers of an input signal in a predetermined time interval, each of said plural powers corresponding to one of plural channels, comprising the steps of:
obtaining auto-correlation functions of said input signals;
providing plural sets of coefficients, each of said sets corresponding to one of said channels; and
obtaining linear-combinations of said auto-correlation functions for said channels by using said sets of coefficients, said linear-combinations being available as said powers.

## Patentansprüche

1. Filter für die Lieferung eines Energieinhalts (9) eines Eingangssignals (3) in einem vorbestimmten Zeitintervall (M), welches umfaßt:
Mittel (4) für das Erhalten von Autokorrelationsfunktionen (5) dieses Eingangssignals (3); und
Mittel (6) für das Erhalten einer linearen Kombination dieser Autokorrelationsfunktionen, wobei diese lineare Kombination als Energieinhalt (9) verfügbar ist.

2. Filter nach Anspruch 1, wobei das Mittel (4) für das Erhalten der Autokorrelationsfunktionen eine Autokorrelationsschaltung (41 - 45) ist.

3. Filter nach Anspruch 1, wobei das Mittel (6) für das Erhalten einer linearen Kombination der Autokorrelationsfunktionen eine Schaltung zur Summierung von Produkten (61a - 61j, 60, 62 - 69) ist.

4. Filter nach Anspruch 1, welches weiterhin Mittel (7) für die Lieferung von Koeffizienten umfaßt, die durch eine Cosinus-Transformation der Frequenzreaktion des Filters definiert werden, wobei diese Koeffizienten durch das Mittel (6) für das Erhalten einer linearen Kombination der Autokorrelationsfunktionen verwendet werden.

5. Filter nach Anspruch 4, wobei das Mittel (7) für die Lieferung von Koeffizienten ein Speichermittel für das Abspeichern dieser Koeffizienten umfaßt.

6. Filter nach Anspruch 1, welches weiterhin Mittel (7) für die Lieferung von Koeffizienten umfaßt, die durch eine Cosinus-Transformation der Frequenzreaktion des Filters und eine Fensterfunktion für das Reduzieren der Anzahl von Graden dieser Autokorrelationsfunktionen (5) definiert werden, wobei diese Koeffizienten durch das Mittel (6) für das Erhalten einer linearen Kombination der Autokorrelationsfunktionen verwendet werden.

7. Filter nach Anspruch 6, bei welchem das Mittel (7) für die Lieferung von Koeffizienten ein Speichermittel für das Abspeichern dieser Koeffizienten umfaßt.

8. Filter für die Lieferung einer Vielzahl von Energieinhalten (9) eines Ausgangssignals (3) in einem vorbestimmten Zeitintervall (M), wobei jede dieser Vielzahl von Energieinhalten einem von mehreren Kanälen entspricht, welches umfaßt:
Mittel (4) für das Erhalten von Autokorrelationsfunktionen (5) des Eingangssignals (3);
Mittel (7) für die Lieferung einer Vielzahl von Sätzen von Koeffizienten, wobei jeder dieser Sätze einem Kanal entspricht; und
Mittel (6) für das Erhalten linearer Kombinationen dieser Autokorrelationsfunktionen, wobei die Autokorrelationsfunktionen als Energieinhalte (9) verfügbar sind.

9. Filter nach Anspruch 8, wobei das Mittel (7) für die Lieferung eine Vielzahl von Sätzen von Koeffizienten ein Speichermittel umfaßt, welches sequentiell diese Sätze von Koeffizienten zu dem Mittel (6) für das Erhalten linearer Kombinationen dieser Autokorrelationsfunktionen liefert.

10. Verfahren für die Bereitstellung des Energieinhalts eines Eingangssignals in einem vorbestimmten Zeitintervall, welches die folgenden Schritte umfaßt:
Erhalten von Autokorrelationsfunktionen dieses Eingangssignals;
Erhalten einer linearen Kombination dieser Autokorrelationsfunktionen durch Verwendung linearer Kombinationskoeffizienten, wobei diese lineare Kombination als der Energieinhalt verfügbar ist.

11. Verfahren für die Bereitstellung mehrerer Energieinhalte eines Eingangssignals in einem vorbestimmten Zeitintervall, wobei jeder dieser mehreren Energieinhalte einem von mehreren Kanälen entspricht, welches die folgenden Schritte umfaßt:
Erhalten von Autokorrelationsfunktionen dieses Eingangssignals;
Bereitstellung von mehreren Sätzen von Koeffizienten, wobei jeder dieser Sätze einem der Kanäle entspricht; und
Erhalten linearer Kombinationen der Autokorrelationsfunktionen für diese Kanäle durch Verwendung dieser Sätze von Koeffizienten, wobei diese linearen Kombinationen als die Energieinhalte zur Verfügung stehen.

## Revendications

1. Filtre permettant de fournir une puissance (9) d'un signal d'entrée (3) dans un intervalle de temps prédéterminé (M), comprenant des moyens (4) permettant d'obtenir des fonctions d'autocorrélation (5) dudit signal d'entrée (3) et des moyens (6) permettant d'obtenir une combinaison linéaire desdites fonctions d'autocorrélation, cette combinaison linéaire étant disponible pour constituer ladite puissance (9).

2. Filtre suivant la revendication 1, dans lequel lesdits moyens (4) permettant d'obtenir des fonctions d'autocorrélation (5) sont constitués par un circuit d'autocorrélation (41-45).

3. Filtre suivant la revendication 1, dans lequel lesdits moyens (6) permettant d'obtenir une combinaison linéaire desdites fonctions d'autocorrélation sont constitués par un circuit de sommation de produits (61a - 61j, 60, 62-69).

4. Filtre suivant la revendication 1, comprenant en outre des moyens (7) permettant de fournir des coefficients définis par une transformation cosinus de réponse en fréquence dudit filtre, lesdits coefficients étant utilisés par lesdits moyens (6) permettant d'obtenir une combinaison linéaire desdites fonctions d'autocorrélation.

5. Filtre suivant la revendication 4, dans lequel lesdits moyens (7) permettant de fournir des coefficients comprennent une mémoire permettant de ranger ces coefficients.

6. Filtre suivant la revendication 1, comprenant en outre des moyens (7) permettant de fournir des coefficients définis par une transformation cosinus de réponse en fréquence dudit filtre et une fonction fenêtre permettant de réduire le nombre de degrés desdites fonctions d'autocorrélation (5), lesdits coefficients étant utilisés par lesdits moyens (6) permettant d'obtenir une combinaison linéaire desdites fonctions d'autocorrélation.

7. Filtre suivant la revendication 6, dans lequel lesdits moyens (7) permettant de fournir des coefficients comprennent une mémoire permettant de ranger lesdits coefficients.

8. Filtre permettant de fournir plusieurs puissances (9) d'un signal d'entrée (3) dans un intervalle de temps prédéterminé (M), chacune desdites multiples puissances correspondant à l'un de multiples canaux, ce filtre comprenant des moyens (4) permettant d'obtenir des fonctions d'autocorrélation (5) dudit signal d'entrée (3), des moyens (7) permettant de fournir plusieurs jeux de coefficients, chacun desdits jeux correspondant à l'un desdits canaux, et des moyens (6) permettant d'obtenir des combinaisons linéaires desdites fonctions d'autocorrélation pour lesdits canaux en utilisant lesdits jeux de coefficients, lesdites combinaisons linéaires étant disponibles pour constituer lesdites puissances (9).

9. Filtre suivant la revendication 8, dans lequel lesdits moyens (7) permettant de fournir plusieurs jeux de coefficients comprennent une mémoire qui fournit successivement lesdits jeux de coefficients auxdits moyens (6) permettant d'obtenir des combinaisons linéaires desdites fonctions d'autocorrélation.

10. Procédé permettant de fournir une puissance d'un signal d'entrée dans un intervalle de temps prédéterminé, comprenant les opérations consistant à obtenir des fonctions d'autocorrélation dudit signal d'entrée et à obtenir une combinaison linéaire desdites fonctions d'autocorrélation en utilisant des coefficients de combinaison linéaire, ladite combinaison linéaire étant disponible de façon à constituer ladite puissance.

11. Procédé permettant de fournir plusieurs puissances d'un signal d'entrée dans un intervalle de temps prédéterminé, chacune desdites multiples puissances correspondant à l'un de multiples canaux, ce procédé comprenant les opérations consistant à obtenir des fonctions d'autocorrélation desdits signaux d'entrée, à fournir plusieurs jeux de coefficients, chacun desdits jeux correspondant à l'un desdits canaux, et à obtenir des combinaisons linéaires desdites fonctions d'autocorrélation pour lesdits canaux en utilisant lesdits jeux de coefficients, lesdites combinaisons linéaires étant disponibles pour constituer lesdites puissances.
